(19) Europäisches Patentamt
European Patent Office
Office européen des brevets

(11) Veröffentlichungsnummer: **0 019 770**
**B1**

(12) **EUROPÄISCHE PATENTSCHRIFT**

(45) Veröffentlichungstag der Patentschrift: **27.07.83**

(51) Int. Cl.³: **G 03 F 7/10,** G 03 F 7/16

(21) Anmeldenummer: **80102516.4**

(22) Anmeldetag: **08.05.80**

(54) **Positiv arbeitendes Schichtübertragungsmittel.**

(30) Priorität: **05.06.79 DE 2922746**

(43) Veröffentlichungstag der Anmeldung: **10.12.80 Patentblatt 80/25**

(45) Bekanntmachung des Hinweises auf die Patenterteilung: **27.07.83 Patentblatt 83/30**

(84) Benannte Vertragsstaaten: **AT BE CH DE FR GB IT LI NL SE**

(56) Entgegenhaltungen:
**DE-A-2 150 691**
**DE-A-2 309 062**
**GB-A-1 161 628**
**US-A-3 782 939**
**US-A-4 071 367**
**US-A-4 075 051**
**US-A-4 193 797**
**SOLID STATE TECHNOLOGY, Band 19, Nr. 8, August 1976, Washington, US, D. G. KELEMEN: »Dry film photoresists in microelectronics«, Seiten 37, 38, 48**
**ELECTRONICS, Band 43, Nr. 26, 21. Dezember 1970, New York, US, S. E. SCRUPSKI: »Dry photoresists gain ground«, Seite 95**

(73) Patentinhaber: **BASF Aktiengesellschaft, Carl-Bosch-Strasse 38, D-6700 Ludwigshafen (DE)**

(72) Erfinder: **Saenger, Dietrich, Dr., Lorcher Ring 16 A, D-6710 Frankenthal (DE)**
Erfinder: **Barzynski, Helmut, Dr., An der Ameisenhalde 49, D-6702 Bad Duerkheim 1 (DE)**

**RESEARCH DISCLOSURE, Nr. 108, April 1973, Homewell Havant Hampshire, GB, »Photographic composition and process suited for the preparation of a photo-resist«, Nr. 10818**

**Die Akte enthält technische Angaben, die nach dem Eingang der Anmeldung eingereicht wurden und die nicht in dieser Patentschrift enthalten sind.**

**EP 0 019 770 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

# Positiv arbeitendes Schichtübertragungsmaterial

Die Erfindung betrifft eine zum positiven Arbeiten geeignete Photolackübertragungsfolie, insbesondere ein lichtempfindliches Schichtübertragungsmaterial, das für die Lamination im trockenen Zustand auf Metalloberflächen sowie sonstige Oberflächen geeignet ist und ein Polymeres mit o-Nitrocarbinolestergruppierungen enthält.

Photolackübertragungsfolien — auch Trocken-Filmresiste genannt — und verschiedene Kombinationen von chemischen Verbindungen für die laminierbaren Kopierschichten sind an sich bekannt. Die z. B. in der DE-AS 1 522 515 oder DE-OS 2 602 410 beschriebenen Kopierschichten sind photopolymerisierbar bzw. lichtvernetzbar und eignen sich für die trockene Laminierung auf Metall- oder andere Oberflächen unter dem gleichzeitigen Einfluß von Druck und erhöhter Temperatur. Werden derartige Kopierschichten bildmäßig belichtet, so liefern sie ein in der Phototechnik üblicherweise als negativ arbeitend bezeichnetes System. Dabei werden jene Bildbereiche, die durch die transparenten Teile einer Kopiervorlage belichtet werden, unlöslich, während die nicht belichteten Bildbereiche relativ unverändert bleiben und durch Auswaschen mit geeigneten Lösungsmitteln entfernbar sind. Das in der Kopierschicht entstandene Bild stellt also eine Umkehrung des Originals dar.

Manchmal ist es wünschenswert, ein positiv arbeitendes Beschichtungsmaterial zur Verfügung zu haben, z. B. wenn ein positives Original vorhanden ist und wenn es wirtschaftlicher ist, dieses Original zu verwenden anstatt von diesem erst eine negative Kopiervorlage herzustellen. Auch können mit einem positiv arbeitenden Kopierlack mehrere Belichtungen hintereinander durchgeführt werden, sofern die nicht ausgewaschenen Bildteile ihre Lichtempfindlichkeit behalten. Es ergibt sich so in der Leiterplattenfertigung die Möglichkeit, mehrere verschiedene galvanische Bäder bzw. Ätzbäder zu durchlaufen, z. B. zuerst ein Kupferätzbad und nach nochmaliger bildmäßiger Belichtung mit einer anderen Kopiervorlage eine galvanische Vergoldung.

Die DE-OS 2 028 903 und DE-OS 2 236 941 beschreiben o-Chinondiazidverbindungen für positiv arbeitende Beschichtungsmaterialien, die bei Belichtung unter Bildung von alkalilöslichen Photolyseprodukten reagieren. Die Materialien haben jedoch eine geringe Lagerstabilität und zeigen bei thermischer Beanspruchung wie beim Laminieren aufgrund der thermischen Instabilität der Diazidgruppen Zersetzungserscheinungen unter Stickstoffabspaltung. Ferner müssen mit diesen Materialien laminierte Metalloberflächen schnell weiterverarbeitet werden, da die Zersetzung der Diazidgruppe durch Schwermetalle und Schwermetallsalze (z. B. in Galvanobädern) katalysiert wird. o-Chinondiazidderivate sind ferner gegen wäßrige Alkalien nicht beständig, was eine weitere Einschränkung ihrer Verwendung bedeutet.

In der US-PS 3 380 825, der DE-AS 2 338 223 und der DE-OS 2 710 417 werden weitere Vorschläge gemacht, um positiv arbeitende Schichten durch bildmäßige Inhibierung von an sich negativ arbeitenden Photopolymer-Beschichtungen zu erhalten. Diese Verfahren benötigen jedoch 2 Belichtungen und sind darüber hinaus äußerst umständlich. Es wird entweder ein gasförmiger Inhibitor benutzt, oder es müssen Kopiergeräte mit unterschiedlicher Strahlungsintensität bzw. Wellenlängen eingesetzt werden. Mehrfachbelichtungen sind nach diesen Verfahren nicht möglich.

In der DE-OS 2 150 691 sind lichtempfindliche Beschichtungsmaterialien beschrieben, die im wesentlichen aus einem Polymeren von einem mittleren Molekulargewicht von größer als 500 besteht, welches zu mindestens 5 Gew.-%, bezogen auf das Molekulargewicht, aromatische oder heteroaromatische o-Nitrocarbinolestergruppierungen der Formel (I)

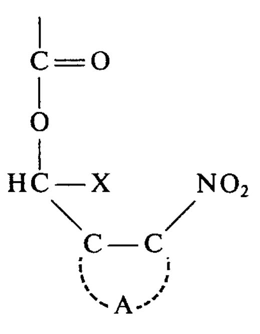

(I)

in der A ein aromatisches oder heteroaromatisches, gegebenenfalls substituiertes Ringsystem mit 5 bis 14 Ringgliedern, X ein Wasserstoffatom, einen Alkylrest mit 1 bis 8 Kohlenstoffatomen oder einen gegebenenfalls substituierten Aryl- oder Aralkylrest bedeuten, im Molekül gebunden enthält und das nach der Belichtung mit einem alkalischen Lösungsmittel oder Lösungsmittelgemisch ausgewaschen werden kann. Die Beschichtungsmaterialien werden insbesondere für positiv arbeitende Flachdruckplatten und als Lichtätzgrund verwendet. Ferner ist aus der DE-OS 2 309 062 bekannt, unter Verwendung von o-Nitrocarbinolesterbeschichtungen Sohictübertragungsmaterial herzustellen. Die

dort beschriebenen Systeme sind jedoch negativ arbeitend.

Aufgabe der vorliegenden Erfindung war es, ein positiv arbeitendes, gegenüber thermischer Beanspruchung unempfindliches und damit lagerstabiles lichtempfindliches Material für Photolack-Übertragungsfolien zu erhalten, das gegenüber Metalloberflächen einerseits und galvanischen Bädern sowie Ätzbädern andererseits so unempfindlich ist, daß es seine Lichtempfindlichkeit behält und somit für Mehrfachbelichtungen geeignet ist.

Es wurde nun gefunden, daß ein positiv arbeitendes Schichtübertragungsmaterial mit einer dimensionsstabilen Trägerfolie, einer darauf aufgebrachten lichtempfindlichen Schicht und gegebenenfalls abziehbaren Deckfolie die gewünschten Eigenschaften zeigt, wenn die lichtempfindliche Schicht im wesentlichen aus einem Polymeren von einem mittleren Molekulargewicht von größer als 500 besteht, welches zu mindestens 5 Gew.-%, bezogen auf das Molekulargewicht, aromatische oder heteroaromatische o-Nitrocarbinolestergruppierungen der Formel (I)

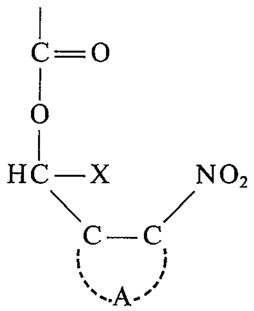

(I)

in der A ein aromatisches oder heteroaromatisches, ggf. substituiertes Ringsystem mit 5 bis 14 Ringgliedern, X ein Wasserstoffatom, einen Alkylrest mit 1 bis 8 Kohlenstoffatomen oder einen ggf. substituierten Aryl- oder Aralkylrest bedeuten, im Molekül gebunden enthält und das nach der Belichtung mit einem alkalischen Lösungsmittel oder Lösungsmittelgemisch ausgewaschen werden kann, und eine mit dem Polymeren verträgliche, im Bereich der Wellenlängen zwischen 300 und 400 nm transparente, weichmachende Verbindung in solcher Menge enthält, daß die optische Dichte der Schicht bei einer Wellenlänge von 360 nm zwischen 0,05 und 3 liegt und die Schicht bei einer üblichen Verarbeitungstemperatur beim Laminieren von oberhalb 40°C soweit erweicht, daß sie auf Metalloberflächen laminiert werden kann.

Die erfindungsgemäßen Schichtübertragungsmaterialien sind hervorragend für die Verwendung als Photolackübertragungsfolien zur Herstellung von elektrischen Leiterplatten, galvanoplastischen Feinätzteilen und Typenschildern geeignet.

Bezüglich der Polymeren mit den o-Nitrocarbinolestergruppierungen der Formel (I) und ihrer Herstellung sei auf die Angaben in der DE-OS 2 150 691 verwiesen. Bevorzugt wird als das den o-Nitrocarbinolestergruppierungen zugrunde liegende Carbinol o-Nitrobenzylalkohol und als tragende Polymere eine Polycarbonsäure wie ein Copolymerisat von Acrylsäure, Methacrylsäure oder Fumarsäure verwandt.

Bevorzugte weichmachende Verbindungen sind Trikresylphosphat und flüssige Polyester aus aliphatischen Dicarbonsäuren und bifunktionellen Glykolen, insbesondere Polyester aus Adipinsäure und 1,2-Propylenglykol oder 1,4-Butandiol mit einer Viskosität von 1000 bis 15 000 cp sowie n-Butyl-benzyl-phthalat.

Den lichtempfindlichen Schichten können noch lösliche Farbstoffe, Pigmente und/oder Verlaufsmittel zugegeben werden. Beispielsweise haben sich als Farbstoffe Sudanfarbstoffe, Azofarbstoffe, Phthalocyanin-Farbstoffe oder Dispersions-Farbstoffe sowie Eosin, Kristallviolett oder Malachitgrün bewährt. Besonders vorteilhaft sind Farbstoffe, die bei der UV-Belichtung ihre Färbung reversibel oder irreversibel ändern. Sudanfarbstoffe oder Azofarbstoffe werden z. B. durch zugesetzte Photoinitiatoren wie Benzoinäther oder Benzophenon bildmäßig ausgebleicht. Als Verlaufsmittel sind Silikonöle gut geeignet.

Weiterhin können den lichtempfindlichen Schichten auch Sensibilisatoren zugesetzt werden, die die Lichtempfindlichkeit und die spektrale Empfindlichkeit der Polymerisate verbessern. Beispiele solcher Sensibilisatoren sind: Xanthenfarbstoffe, wie Fluorescein, Eosin und Rhodamin S, sowie Triplet-Energieüberträger, wie sie beispielsweise N. J. Turro in seinem Buch Molecular Photochemistry, W. A. Benjamin Inc., New York, 1967, auf Seite 132 beschreibt.

Für die Herstellung der erfindungsgemäßen Schichtübertragungsmaterialien kann man die einzelnen Komponenten der lichtempfindlichen Schicht in einem geeigneten Lösungsmittel, z. B. Aceton, Essigester oder Methylenchlorid, vermischen und nach bekannten Methoden, wie durch Gießen auf einen dimensionsstabilen Folienträger — bevorzugt wird Polyäthylenterephthalatfolie — in gleichmäßiger Schicht einer Stärke von 0,005 bis 0,1 mm auftragen und das Lösungsmittel dann abdampfen unter Entstehung der lichtempfindlichen Schicht auf dem Schichtträger. Nach Abdampfen des Lösungsmittels sind die lichtempfindlichen Schichten häufig noch etwas weich und

klebrig. Um die Lagerung und Weiterverarbeitung zu erleichtern, wird noch eine schützende Deckfolie aufgebracht. Besonders geeignet sind hierfür Folien aus Polyäthylen oder Polypropylen. Natürlich können auch Folien aus Lösung auf die lichtempfindliche Schicht gegossen werden, z. B. eine Schicht von Polyvinylalkohol aus wäßriger Lösung aufgetragen werden. Das fertige, zum positiven Arbeiten befähigte Schichtübertragungsmaterial wird dann nach Abziehen der Deckfolie unter dem Einfluß von Wärme und Druck auf die zu verarbeitende Oberfläche, z. B. Metalloberfläche laminiert, bildmäßig entweder durch die Trägerfolie oder nach Abziehen der bevorzugt abziehbaren Trägerfolie mit UV-Licht belichtet. Die durch die Belichtung alkalilöslich gewordenen Bildteile werden anschließend mit einer alkalischen Entwicklerflüssigkeit ausgewaschen und die freigelegten Oberflächen, wie Metalloberflächen, geätzt bzw. galvanisch weiterbehandelt. Nach Fertigstellung des Formteils kann der unbelichtete Teil des Photolacks durch Behandlung mit einem polaren orgaischen Lösungsmittel wie Aceton, Äthylacetat, Äthylglykolmonobutyläther restlos entfernt werden.

Von besonderem Vorteil ist die völlige Beständigkeit der lichtempfindlichen o-Nitrocarbinolestergruppierungen wie o-Nitrobenzylgruppen enthaltenden Polymeren sowohl gegenüber thermischer Belastung als auch gegenüber Metalloberflächen, Metallsalzlösungen und stark alkalischen Medien. Das Resistmaterial ist diesen Einflüssen beim Laminieren auf z. B. Kupfer-Oberflächen und bei den nachfolgenden Verarbeitungsschritten wie Ätzen und Galvanisieren ausgesetzt. Auf Grund dieser Resistenz ist es mit dem erfindungsgemäßen Photoübertragungslacksystem im Gegensatz zu solchem auf Diazooxidbasis und allen Negativsystemen möglich, die jeweils stehenbleibenden Bildteile nach Durchlaufen von Entwicklung, Ätzbädern und Galvanotechnik erneut zu belichten etc. Eine Möglichkeit zur Mehrfachbelichtung eröffnet neue Anwendungsmöglichkeiten für Photoresistmaterial, z. B. die galvanische Vergoldung von Steckkontaktleisten oder die Herstellung von Platinen, die inmitten der Leiterbahnzüge mit Edelmetallen galvanisch verstärkte Druckpunkt- oder Schleifkontaktschalter besitzen.

Die in den nachstehenden Beispielen genannten Teile und Prozente beziehen sich, soweit nicht anders angegeben, auf das Gewicht. Volumenteile verhalten sich zu Teilen wie Liter zu Kilogramm.

## Beispiel 1

### (Herstellung eines lichtempfindlichen Terpolymerisates)

40 Teile o-Nitrobenzylacrylat, 59 Teile Methylmethacrylat, 1 Teil Acrylsäure und 1 Teil Azodiisobutyronitril werden in 150 Vol.-Teilen Essigester gelöst. Vor dem Erhitzen am Rückfluß wird der Luftsauerstoff durch Spülen mit Stickstoff verdrängt. Es wird 24 Stunden unter Rühren am Rückfluß gekocht, wobei nach 8 bzw. 16 Stunden jeweils 1 Teil Azodiisobutyronitril zugesetzt wird. Das Terpolymerisat wird durch Eintropfen der Polymerlösung in Methanol gefällt und bei 40°C im Vakuumschrank getrocknet. Ausbeute: 96 Teile eines weißen, flockigen Pulvers. N-Gehalt: 2,8% (entsprechend 41,2% o-Nitrobenzylacrylat). K-Wert nach H. Fikentscher (Cellulose-Chemie 30 (1931) 58): 21 (1%ige Lösung in Essigester). Säuregehalt: 1,05% Acrylsäure.

Die anfallende Polymerlösung kann auch direkt zur Herstellung von lichtempfindlichen Schichten eingesetzt werden.

Auf analoge Weise können anders zusammengesetzte Copolymerisate hergestellt werden. Je nach Art und Menge der Comonomeren werden Copolymere erhalten, deren Glasübergangstemperatur Tg nach Wunsch in weiten Grenzen variierbar ist. Zur Veranschaulichung sind in der folgenden Tabelle einige Polymerisate von o-Nitrobenzylacrylat mit deren Glastemperatur aufgelistet.

| o-NB-Acrylat % | Comonomere % | % | Tg °C |
|---|---|---|---|
| 100 | – | | ca. 25 |
| 80 | 20 MMA | | 35 |
| 60 | 40 MMA | | 53 |
| 40 | 60 MMA | | 70 |
| 20 | 80 MMA | | 84 |
| – | 100 MMA | | 105 |
| 40 | 59 MMA | 1 AS | 65 |
| 40 | 60 AN | | 53 |
| 40 | 60 t-BA | | 40 |
| 40 | 50 MMA | 10 t-BA | 60 |
| 40 | 40 MMA | 20 t-BA | 51 |
| 40 | 30 MMA | 30 t-BA | 54 |

MMA = Methylmethacrylat.
AN = Acrylnitril.
o-NB-Acrylat = o-Nitrobenzylacrylat.
t-BA = tert.-Butylacrylat.
AS = Acrylsäure.

## Beispiel 2

(Herstellung einer Photolackübertragungsfolie)

Eine Lösung aus 40 Teilen lichtempfindlichem Copolymerisat des Beispiels 1, 18 Teilen eines flüssigen Polyesters aus Adipinsäure und Butandiol (Viskosität 7000 cP bei 20°C), 0,58 Teilen Benzildimethylketal sowie 0,18 Teilen des Farbstoffs Solventblack 3, CI 26 150, in 160 Vol.-Teilen Essigester werden nach Filtration durch ein 1,5-μm-Membranfilter mit Hilfe einer Rakel auf eine 25 μm dicke, thermofixierte Polyäthylenterephthalatfolie gleichmäßig aufgetragen. Die Naßfilmdicke wird so gewählt, daß nach dem Trocknen eine 10 bis 30 μm dicke Photolackschicht resultiert. Zum Schutz vor Schmutz etc. wird der Photolackfilm mit einer 25 μm dicken Folie aus Niederdruckpolyäthylen abgedeckt. Die Photolackübertragungsfolie wird randbeschnitten und auf einen Pappkern aufgewickelt.

## Beispiel 3

(Herstellung einer Leiterplatte (Subtraktiv-Verfahren))

Vor der Verwendung als trockenlaminierbarer Photolack wird in einem handelsüblichen Laminator die Polyäthylendeckfolie abgezogen und der Positivlack auf vorgebürstete und gründlich entfettete, kupferplattinierte Epoxidharz-Glasfaserplatten bei 100—120°C mit einer Geschwindigkeit von 0,5 bis 1,5 m/min aufkaschiert. Eine so mit Photolack beschichtete Kupferplatte wird durch eine photographische Positivvorlage durch die Trägerfolie hindurch 2 Minuten in einem branchenüblichen Belichtungsgerät belichtet. Die belichteten Bildteile bleichen hierbei partiell aus, wodurch ein guter Kontrast zu den unbelichteten Bildelementen entsteht. Dieser Effekt verstärkt sich beim Lagern weiter, so daß eine Verwechslung mit unbelichteten Platten ausgeschlossen ist. Die Polyesterfolie wird daraufhin abgezogen und die belichteten Bildteile mit einem Entwicklergemisch aus 81% Wasser, 16% 2-Butoxyäthanol und 3% Triäthanolamin in 1 bis 1,5 min ausgewaschen. Es wird ein blaues, scharfkantiges Bild der Vorlage erhalten, das durch Abblasen mit Druckluft von Entwicklerresten

befreit wird. Anschließend wird in einem handelsüblichen Ätzbad bei 40—50°C die nicht abgedeckte Kupferschicht weggeätzt, dann mit Wasser gespült und getrocknet. Der Photolack zeichnet sich durch sehr gute Ätzresistenz sowohl gegen saure Ätzmedien wie $FeCl_3$, $(NH_4)_2S_2O_8$ oder $CuCl_2$, als auch alkalischen Ätzmedien wie ammoniakalische Bäder aus. Anschließend wird durch Spülen mit einem polaren Lösungsmittel (Aceton, Essigester) das Photolackbild abgelöst. Die Leiterbahnen sind kantenscharf und nicht unterätzt. Das Photoresistmaterial ist auch zur Herstellung durchkontaktierter Schaltungen gut geeignet, da die Bohrlöcher beim Laminieren dauerhaft über alle Prozeßschritte überdeckt werden.

Beispiel 4

(Stufenweise Mehrfachbelichtung)

Eine nach Beispiel 3 mit positivem Photoresist laminierte kupferkaschierte Basisplatte wird in 3 Felder aufgeteilt. Zunächst wird Feld 1 (unter Abdeckung von Feld 2 und 3 mit schwarzer Folie) wie oben beschrieben belichtet, entwickelt und geätzt. Die Abdeckung bezieht sich nur auf den Belichtungsschritt, bei allen weiteren Operationen wird die Behandlung mit der gesamten Platte durchgeführt.

Man erhält in Feld 1 ein noch mit Resist abgedecktes Abbild der positiven Bildvorlage, während die Felder 2 und 3 vollflächig mit Photoresist abgedeckt sind. Anschließend wird Feld 1 und 3 abgedeckt und Feld 2 durch ein Positiv belichtet. Nach Durchlaufen aller Arbeitsschritte resultiert eine Platte, die in Feld 1 und 2 ein geätztes Leiterbahnmuster enthält und in Feld 3 noch voll durch den ursprünglich auflaminierten Photoresist abgedeckt ist. Nach Abdecken der Felder 1 und 2 wird Feld 3 belichtet. Obwohl dieses Feld je zweimal dem Entwicklungs- sowie dem Ätzschritt ausgesetzt war, resultiert ein sauber ausgewaschenes Bild, das ein ebenso scharfkantiges Ätzen wie in den beiden Vorstufen erlaubt. Nach Ablösen des verbleibenden Photolacks mit Aceton wird eine Platte erhalten, die in allen 3 Feldern der jeweiligen Positivvorlage genau entsprechende Ätzbilder wiedergibt.

Beispiel 5

(Verwendung als Galvanoresist)

Eine nach Beispiel 3 mit Positivphotoresist laminierte Kupferplatte wird durch eine Negativvorlage 3 min belichtet, entwickelt und anschließend 10 Minuten bei 80°C getrocknet. In einer Galvanikanlage werden unter Einsatz handelsüblicher Galvanikbäder nacheinander 5 µm Nickel und 3 µ Gold abgeschieden. Durch Spülen mit Aceton wird der restliche Photoresist abgelöst und das freistehende Kupfer mit einer 20prozentigen $(NH_4)_2S_2O_8$-Lösung weggeätzt. Es wird eine einwandfreie Leiterplatte erhalten, die sich durch scharfe Leiterbahnkanten auszeichnet. Der Photoresistfilm eignet sich als Galvanoresist bei der bildmäßigen Abscheidung einer Vielzahl anderer Metalle, z. B. beim galvanischen Aufbau von Kupfer oder Zinn bzw. Zinn/Blei-Legierungen.

Beispiel 6

(Einsatz als Ätzresist und Galvanoresist durch Zweifachbelichtung)

Bei der Herstellung von Platinen, die inmitten von Leiterbahnen vergoldete Kontakte für z. B. Schleifkontaktschalter benötigen, ist entweder ein zweimaliges Abdecken mit Negativresist oder ein doppelter Siebdruck nötig. Eine elegante Lösung bietet der erfindungsgemäße Positivphotoresist, der auch nach Kontakt mit schwermetallsalzhaltigen Galvanikbädern noch photoaktiv ist. Er erlaubt dadurch die unterschiedliche bildmäßige Abscheidung mehrerer Metalle bzw. die Verwendung als Ätzresist und nach einer zweiten Belichtung als Galvanoresist mit Hilfe eines einzigen Abdeckschrittes.

Eine nach Beispiel 3 laminierte Kupferplatine wird zunächst durch ein Positiv 1 belichtet, entwickelt und die freigelegten Kupferflächen weggeätzt. Nach erneutem Belichten durch eine photographische Vorlage 2, die nach dem Entwickeln die bildmäßige Freilegung der Schleifkontakte ergibt, werden diese galvanisch vergoldet. Durch Spülen mit Aceton werden die verbleibenden Resistteile rückstandslos weggelöst, so daß anschließende Lötvorgänge störungsfrei durchgeführt werden können.

Beispiel 7

(Beständigkeit des Resistfilms
gegenüber Ätz- und Galvanomedien sowie thermischer Belastung)

Zum Beständigkeitsvergleich werden kupferbeschichtete Epoxidharzplatten mit zwei chemisch unterschiedlich aufgebauten, positiv arbeitenden Resistmaterialien beschichtet:

Probe A: erfindungsgemäßes Resistmaterial
Probe B: Photolack auf Basis eines o-Naphthochinondiazid-5-sulfonsäure-Novolak-Derivates.

Zum Beständigkeitsvergleich werden die unbelichteten Probeplatten bei 140° C getempert sowie in wäßrigem Alkali (5prozentige NaOH) und schwermetallsalzhaltiger Lösung (Galvanikbad) gelagert. Die erhaltenen Ergebnisse sind in der nachstehenden Tabelle zusammengestellt.

| Probe | Tempern 140°C | | 2stündiges Lagern in 5prozentiger NaOH | 2stündiges Lagern in | |
|---|---|---|---|---|---|
| | 1 h | 24 h | | Cu-Bad | Ag-Bad |
| A | ++ | ++ | ++ | ++ | ++ |
| B | 0 | 0 | – | 0 | 0 |

++) Resist voll lichtempfindlich, Schicht nicht angegriffen.
0 = Resist nicht mehr lichtempfindlich.
– = Resist total abgelöst.

Die Ergebnisse zeigen die überragende themische Beständigkeit des erfindungsgemäßen Schichtübertragungsmaterials sowie seine Resistenz gegenüber Prozeßchemikalien.

Beispiel 8

Eine Leiterplatte wird gemäß Beispiel 3 hergestellt, jedoch wird das Photolackbild nicht mit einem polaren organischen Lösungsmittel entfernt, sondern nach nochmaliger zweiminütiger Vollflächenbelichtung mit dem in Beispiel 3 angegebenen ersten wäßrigen Entwicklergemisch abgewaschen. Diese Verarbeitungsweise erlaubt das Arbeiten mit nur einem wäßrigen Entwicklergemisch bzw. nur einem Entwicklungsgerät (Sprühwascher).

**Patentansprüche**

1. Positiv arbeitendes Schichtübertragungsmaterial mit einer dimensionsstabilen Trägerfolie, einer darauf aufgebrachten lichtempfindlichen Schicht und gegebenenfalls einer abziehbaren Deckfolie, dadurch gekennzeichnet, daß die lichtempfindliche Schicht im wesentlichen aus einem Polymeren von einem mittleren Molekulargewicht von größer als 500 besteht, welches zu mindestens 5 Gew.-%, bezogen auf das Molekulargewicht, aromatische oder heteroaromatische o-Nitrocarbinolestergruppierungen der Formel (I)

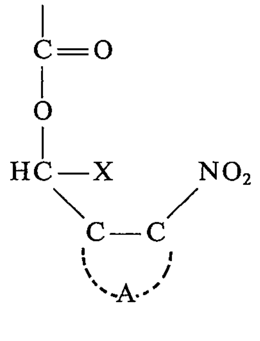

(I)

in der A ein aromatisches oder heteroaromatisches, gegebenenfalls substituiertes Ringsystem mit 5

bis 14 Ringgliedern, X ein Wasserstoffatom, einen Alkylrest mit 1 bis 8 Kohlenstoffatomen oder einen gegebenenfalls substituierten Aryl- oder Aralkylrest bedeuten, im Molekül gebunden enthält und das nach der Belichtung mit einem alkalischen Lösungsmittel oder Lösungsmittelgemisch ausgewaschen werden kann, und eine mit dem Polymeren verträgliche, im Bereich der Wellenlängen zwischen 300 und 400 nm transparente, weichmachende Verbindung in solcher Menge enthält, daß die optische Dichte der Schicht bei einer Wellenlänge von 360 nm zwischen 0,05 und 3 liegt und die Schicht bei einer üblichen Verarbeitungstemperatur beim Laminieren von oberhalb 40° C soweit erweicht, daß sie auf Metalloberflächen laminiert werden kann.

2. Schichtübertragungsmaterial nach Anspruch 1, dadurch gekennzeichnet, daß im Polymeren das den o-Nitrocarbinolestergruppierungen zugrunde liegende Carbinol o-Nitrobenzylalkohol ist.

3. Schichtübertragungsmaterial nach den Ansprüchen 1 oder 2, dadurch gekennzeichnet, daß das o-Nitrocarbinolestergruppierungen tragende Polymere sich von einem Homo- oder Copolymerisat der Acrylsäure, Methacrylsäure, Maleinsäure und/oder Fumarsäure ableitet.

4. Schichtübertragungsmaterial nach einem der Ansprüche 1 bis 3, dadurch gekennzeichnet, daß es als weichmachende Verbindung Trikresylphosphat oder einen Polyester aus aliphatischen Dicarbonsäuren und aliphatischen Glykolen mit einer Viskosität von 1000—15 000 cp oder n-Butyl-benzyl-phthalat enthält.

## Claims

1. A positive working photosensitive film resist material consisting of a dimensionally stable base film and a photosensitive coating applied thereto, with or without a strippable protective film, wherein the photosensitive coating consists essentially of a polymer which has a mean molecular weight greater than 500, contains, chemically bonded in the molecule, not less than 5% by weight, based on the polymer molecular weight, of aromatic or hetero-aromatic o-nitrocarbinol ester groups of the formula (I)

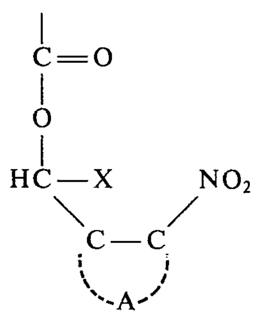

(I)

where A is an aromatic or hetero-aromatic, unsubstituted or substituted ring system with from 5 to 14 ring members and X is hydrogen, alkyl of 1 to 8 carbon atoms or unsubstituted or substituted aryl or aralkyl, and can, after exposure, be washed out with an alkaline solvent or solvent mixture, and a plasticizing compound which is compatible with the polymer and is transparent in the wavelength range of from 300 to 400 nm, this compound being present in such an amount that the optical density of the coating at a wavelength of 360 nm is form 0.05 to 3 and that the coating softens sufficiently, on lamination at a conventional processing temperature of above 40° C, that it can be laminated onto metal surfaces.

2. A photosensitive film resist material as claimed in claim 1, wherein the carbinol on which the o-nitrocarbinol ester groups in the polymer are based is o-nitrobenzyl alcohol.

3. A photosensitive film resist material as claimed in claim 1 or 2, wherein the polymer bearing o-nitrocarbinol ester groups is derived from a homopolymer or copolymer of acrylic acid, methacrylic acid, maleic acid and/or fumaric acid.

4. A photosensitive film resist material as claimed in any of claims 1 to 3, wherein the plasticizing compound is tricresylphosphate or a polyester obtained from aliphatic dicarboxylic acid and aliphatic glycols and having a viscosity of 1,000 to 15,000 cp, or n-butyl benzyl phthalate.

## Revendications

1. Matériau de transfert en couche, travaillant en positif, comportant une feuille support, stable en dimension, une couche sensible à la lumière appliquée sur la précédente et éventuellement une feuille de recouvrement détachable, caractérisé par le fait que la couche sensible à la lumière est constituée essentiellement d'un polymère de poids moléculaire moyen supérieur à 500, qui, pour au moins 5% en poids, rapportés au poids moléculaire, contient, liés à la molécule, des groupements o-nitrocarbinolester, aromatiques ou hétéro-aromatiques de formule (I)

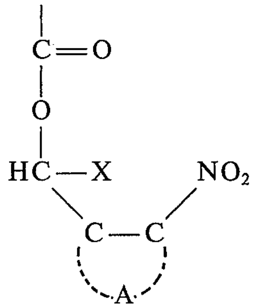

(I)

dans laquelle A représente un système cyclique à 5 à 14 chaînons, aromatique ou hétéro-aromatique, éventuellement substitué, X un atome d'hydrogène, un reste alkyle à 1 à 8 atomes de carbone ou un reste aryle ou aralkyle, éventuellement substitué, et qui peut être éliminé par lavage, après exposition avec un solvant ou mélange de solvant alcalin, et contient un composé plastifiant, transparent dans la zone des longueurs d'onde comprise entre 300 et 400 nm, et compatible avec le polymère, en quantité telle que la densité optique de la couche, pour une longueur d'onde de 360 nm, est comprise entre 0,05 et 3, et la couche, à une température de traitement usuelle, lors d'un laminage au-dessus de 40° C, se ramollit tant qu'elle peut être appliquée par laminage sur des surfaces métalliques.

2. Matériau de transfert en couche, selon la revendication 1, caractérisé par le fait que, dans le polymère, le carbinol servant de base aux groupements o-nitrocarbinolester est le o-nitrobenzylalcool.

3. Matériau de transfert en couche selon les revendications 1 ou 2, caractérisé par le fait que le polymère portant les groupements o-nitrocarbinolester dérive d'un homo- ou copolymère d'acide acrylique, méthacrylique, maléique et/ou fumarique.

4. Matériau de transfert en couche, selon l'une des revendications 1 à 3, caractérisé par le fait qu'il contient, comme composé plastifiant, du tricrésylphosphate ou un polyester provenant d'acides dicarboxyliques aliphatiques et des glycols aliphatiques d'une viscosité de 1000 à 15 000 cp ou du n-butyl-benzyl-phthalate.